# EUROPEAN PATENT SPECIFICATION

(11) **EP 4 556 919 B1**
(45) Date of publication and mention of the grant of the patent: **04.11.2026**
(21) Application number: 22954425.9
(22) Date of filing: 10.08.2022
(51) Int. Cl.: G01R 31/36, G01R 31/364, G01R 31/385, B60L 58/10, H01M 10/48

(54) **COMMUNICATION MODULE, AND WIRELESS TEST SYSTEM AND TEST METHOD FOR BATTERY**
KOMMUNIKATIONSMODUL UND DRAHTLOSES TESTSYSTEM UND TESTVERFAHREN FÜR BATTERIE
MODULE DE COMMUNICATION, ET SYSTÈME DE TEST SANS FIL ET PROCÉDÉ DE TEST POUR BATTERIE

(43) Date of publication of application: 21.05.2025
(73) Proprietor: Contemporary Amperex Technology Co., Limited, Ningde, Fujian 352100 (CN)
(72) Inventor: LIAN, Dengwei, Ningde, Fujian 352100 (CN); ZHAO, Tong, Ningde, Fujian 352100 (CN); CHEN, Chen, Ningde, Fujian 352100 (CN); LI, Yanghu, Ningde, Fujian 352100 (CN); ZHAO, Bin, Ningde, Fujian 352100 (CN)
(74) Representative: Lorenz Seidler Gossel Part. mbB
(86) International application number: PCT/CN2022/111513
(87) International publication number: WO 2024/031450

(56) References cited:
- WO-A1-2021/207358
- CN-A- 107 290 667
- CN-A- 107 688 153
- CN-A- 112 886 683
- CN-A- 113 219 348
- CN-U- 203 894 392
- CN-U- 203 894 392
- CN-U- 208 423 100

## Description

### Technical Field

The present application relates to the field of batteries, and in particular, to a communication module and a wireless test system and method for a battery.

### Background Art

In a production process of a battery, a test station is provided before a hoisting station, and is configured to test the battery before the battery is off the production line, to determine whether the battery meets factory requirements.

Currently, when the battery is tested on the test station, there are problems of a long test cycle and a low test efficiency. An exemplary production-line monitoring architecture is known from CN 203 894 392 U. The disclosed architecture comprises at least one production line monitoring unit and a monitoring center. In each production line monitoring unit, multiple single monitoring modules, one group end monitoring module and a chemical measurement controller connected to the monitoring center are described. Each single monitoring module has a wired connection to batteries in a battery pack and all batteries are connected by wire to the group end monitoring module. Each single monitoring module and the group-end monitoring module are connected to the chemical measurement controller wirelessly. The measurement controller may obtain a charging task or a discharging task from a user energy monitoring center. Once authorized, the single monitoring modules and the group monitoring module perform monitoring. The results are transmitted to the chemical measurement controller and uploaded to the monitoring center. The chemical measurement controllers are connected to the user energy monitoring center through an RS485 bus, while connections to the monitoring center are disclosed as being made through an Ethernet (RJ45) interface. A virtual testing system for battery management systems, in which battery cell voltages are electronically simulated rather than provided by physical battery cells is disclosed in CN 113 219 348 A.

### Summary of the Invention

An objective of embodiments of the present application is to provide a communication module and a wireless test system and method for a battery, which are used to shorten the test cycle on the test station and improve the test efficiency.

According to a first aspect, an embodiment of the present application provides a communication module, and the communication module includes a wireless communication interface and a wired communication interface.

The communication module is in wireless communication connection to a test terminal through the wireless communication interface, and is connected to a battery under test through the wired communication interface, to implement mutual communication between the test terminal and the battery under test, that is, the communication module receives instruction data sent by the test terminal, and sends a test instruction to the battery under test. The battery under test generates a corresponding battery parameter according to the received test instruction, and sends test data corresponding to the battery parameter to the communication module. The communication module sends, to the test terminal, the test data returned by the battery under test.

This embodiment of the present application implements the wireless test of the battery under test through a communication module, where test items that can be implemented through wireless testing can be implemented before the battery under test arrives at a test station or after the battery under test leaves the test station. This reduces test items on the test station, shortens the test cycle on the test station, and improves the test efficiency. In addition, the system provided in this embodiment of the present application can also perform a test in parallel with a wired test on the test station, which improves the test efficiency.

Although not part of the invention, the battery under test may be connected to the wired communication interface through a wire harness. The battery under test may be connected to the communication module through a wire harness. A wireless test for some test items of the battery under test can be implemented without changing a structure of the battery under test, and therefore, a wired test does not need to be performed for these test items again on the test station. This shortens the test cycle on the test station and improves the test efficiency.

The communication module is integrated into the battery under test. The communication module is integrated into the battery under test, so that the battery under test has a wireless communication function. Then, a wireless test for some test items of the battery under test can be implemented, and therefore, a wired test does not need to be performed for these test items again on the test station. This shortens the test cycle on the test station and improves the test efficiency.

In any embodiment, the communication module includes a signal conversion module configured to convert a signal type of the instruction data into a signal type suitable for the battery under test, and send, to the battery under test, a test instruction obtained after the conversion.

In this embodiment of the present application, the communication module includes the signal conversion module that can convert the signal type of the instruction data sent by the test terminal into a signal type recognizable by the battery under test, thereby ensuring the smooth execution of a wireless test process.

In any embodiment, the communication module further includes a first controller, where the first controller is configured to receive a first channel switching instruction sent by the test terminal, and control, according to the first channel switching instruction, the signal conversion module to perform channel switching.

Since different test items require different wireless channels, when a number of channels is insufficient, channel switching is performed through the first controller, thereby implementing a wireless test of the battery under test, reducing test items for a wired test of the battery under test on the test station, and improving the test efficiency.

In any embodiment, the communication module further includes a second controller, where the signal conversion module is further configured to receive a second channel switching instruction sent by the test terminal, and send the second channel switching instruction to the second controller; and the second controller controls, according to the second channel switching instruction, the signal conversion module to perform channel switching.

Since different test items require different wireless channels, when a number of channels is insufficient, channel switching is performed through the second controller, thereby implementing a wireless test of the battery under test, reducing test items for a wired test of the battery under test on the test station, and improving the test efficiency.

In any embodiment, the communication module further includes a power supply, where the power supply is configured to power the battery under test. In this embodiment of the present application, the communication module powers a low-voltage circuit of the battery under test, so that the battery under test can be woken up through the power supply, and the communication module can obtain the battery parameter of the battery under test, to complete a wireless test.

In any embodiment, the foregoing test instruction includes at least one of a BMS master control test instruction, a BMS slave control test instruction, a minimum voltage test instruction, a maximum voltage test instruction, a minimum temperature test instruction, a maximum temperature test instruction, an SOC detection instruction, an interlock signal fault detection instruction, a slow charging function detection instruction, and a fast charging function detection instruction.

In this embodiment of the present application, for the foregoing test items that can be completed through wireless communication, data interaction between the battery under test and the test terminal is implemented by using the communication module, to complete the wireless test, thereby reducing test items for a wired test of the battery under test on the test station, and improving the test efficiency.

According to a second aspect, an embodiment of the present application provides a wireless test system for a battery, and the system includes a test terminal and the communication module of the first aspect.

In this embodiment of the present application, the communication module is in wireless communication connection to the test terminal, and is connected to a battery under test in a wired manner, so that a wireless test of the battery under test can be implemented, thereby reducing test items for a wired test on the test station, shortening the test cycle on the test station, and improving the test efficiency.

On the basis of the foregoing embodiment, there are a plurality of communication modules, and the test terminal is configured to wirelessly test a plurality of batteries under test by using the plurality of communication modules.

In this embodiment of the present application, the plurality of batteries under test can be tested through communication connection between the test terminal and a plurality of communication modules, thereby improving the test efficiency.

According to a third aspect, an embodiment of the present application provides a wireless test method for a battery, and the method is used for testing a battery under test, where the battery under test is communicatively connected to a test terminal through a communication module. The method includes:
receiving, by the communication module, instruction data sent by the test terminal, and sending a test instruction corresponding to the instruction data to the battery under test;
returning, by the battery under test, a corresponding battery parameter to the communication module according to the test instruction;
after receiving the battery parameter, the communication module sends test data corresponding to the battery parameter to the test terminal; and
generating, by the test terminal, a test result based on the test data.

This embodiment of the present application implements the test of the battery under test through wireless communication, where test items that can be implemented through wireless testing can be implemented before the battery under test arrives at a test station or after the battery under test leaves the test station. This reduces test items on the test station, shortens the test cycle on the test station, and improves the test efficiency. In addition, the system provided in this embodiment of the present application can also perform a test in parallel with a wired test on the test station, which improves the test efficiency.

In any embodiment, the communication module is connected to the battery under test through a wire harness.

In this embodiment of the present application, the battery under test is connected to the communication module through a wire harness. A wireless test for some test items of the battery under test can be implemented without changing a structure of the battery under test, and therefore, a wired test does not need to be performed for these test items again on the test station. This shortens the test cycle on the test station and improves the test efficiency.

The communication module is integrated into the battery under test.

The communication module is integrated into the battery under test, so that the battery under test has a wireless communication function. Then, a wireless test for some test items of the battery under test can be implemented, and therefore, a wired test does not need to be performed for these test items again on the test station. This shortens the test cycle on the test station and improves the test efficiency.

In any embodiment, the communication module includes a signal conversion module and a first controller; both the signal conversion module and the first controller are communicatively connected to the test terminal; and before the receiving instruction data sent by the test terminal, the method further includes:
receiving, by the first controller, a first channel switching instruction sent by the test terminal, and controlling, according to the first channel switching instruction, the signal conversion module to perform CAN channel switching.

Since different test items require different wireless channels, when a number of channels is insufficient, channel switching is performed through the first controller, thereby implementing a wireless test of the battery under test, reducing test items for a wired test of the battery under test on the test station, and improving the test efficiency.

In any embodiment, the communication module includes a signal conversion module and a second controller; the signal conversion module is communicatively connected to the test terminal; and before the receiving instruction data sent by the test terminal, the method further includes:
receiving, by the signal conversion module, a second channel switching instruction sent by the test terminal, and forwarding the second channel switching instruction to the second controller, where the second controller controls, according to the second channel switching instruction, the signal conversion module to perform CAN channel switching.

Since different test items require different wireless channels, when a number of channels is insufficient, channel switching is performed through the second controller, thereby implementing a wireless test of the battery under test, reducing test items for a wired test of the battery under test on the test station, and improving the test efficiency.

In any embodiment, before the battery under test arrives at a test station, a test process corresponding to the method is completed.

In this embodiment of the present application, the wireless test process is controlled to be completed before the battery under test arrives at the test station, so that the battery under test only needs to be tested for other test items on the test station. This reduces a number of test items on the test station, and improves the test efficiency.

In any embodiment, after the battery under test leaves a test station, a test process corresponding to the test method starts to be executed.

In this embodiment of the present application, the wireless test process is controlled to start to be executed after the battery under test leaves the test station, so that the battery under test only needs to be tested for other test items on the test station. This reduces a number of test items on the test station, and improves the test efficiency.

In any embodiment, the test terminal sends the instruction data to the communication module after it is detected that the battery under test has reached a preset station.

In this embodiment of the present application, a position of the battery under test is monitored through the test terminal, and a wireless test is started after the battery under test arrives at the preset station, so that some test items are performed through the wireless test, and a test time on the test station is not required, thereby improving the test efficiency.

In any embodiment, there are a plurality of communication modules, and each of the communication modules is connected to at least one battery under test.

In this embodiment of the present application, the plurality of batteries under test can be tested through communication connection between the test terminal and a plurality of communication modules, thereby improving the test efficiency.

In any embodiment, the test instruction includes at least one of a battery management system BMS master control test instruction, a BMS slave control test instruction, a minimum voltage test instruction, a maximum voltage test instruction, a minimum temperature test instruction, a maximum temperature test instruction, an SOC detection instruction, an interlock signal fault detection instruction, a slow charging function detection instruction, and a fast charging function detection instruction.

In this embodiment of the present application, for the foregoing test items that can be completed through wireless communication, data interaction between the battery under test and the test terminal is implemented by using the communication module, to complete the wireless test, thereby reducing test items for a wired test of the battery under test on the test station, and improving the test efficiency.

Other features and advantages of the present application will be set forth in the specification which follows, and in part will be apparent from the specification, or may be understood by the implementation of the embodiments of the present application. The objectives and other advantages of the present application may be achieved and obtained by the structure particularly pointed out in the specification described herein, claims, and the accompanying drawings.

### Brief Description of the Drawings

In order to more clearly describe the technical solutions of the embodiments of the present application, the accompanying drawings required in the embodiments of the present application will be described briefly below. It should be understood that the following accompanying drawings illustrate only some embodiments of the present application and therefore should not be construed as a limitation on the scope thereof. For those of ordinary skill in the art, other relevant accompanying drawings can also be obtained from these accompanying drawings without any creative effort.
FIG. 1 is a schematic diagram of a structure of a first type of communication module according to an embodiment of the present application;
FIG. 2 is a schematic diagram of a communication module being connected to a battery under test not having a wireless communication function according to an embodiment of the present application;
FIG. 3 is a schematic diagram of a battery under test having a wireless communication function being connected to a communication module according to an embodiment of the present application;
FIG. 4 is a schematic diagram of a structure of a second type of communication module according to an embodiment of the present application;
FIG. 5 is a schematic diagram of a structure of a third type of communication module according to an embodiment of the present application;
FIG. 6 is a diagram of a structure of a fourth type of communication module according to an embodiment of the present application;
FIG. 7 is a schematic diagram of a structure of a communication module powered by an external device according to an embodiment of the present application;
FIG. 8 is a schematic diagram of a structure of a wireless test system for a battery according to an embodiment of the present application;
FIG. 9 is a schematic diagram of a structure of another wireless test system for a battery according to an embodiment of the present application;
FIG. 10 is a schematic flowchart of a wireless test method for a battery according to an embodiment of the present application;
FIG. 11 is a schematic flowchart of another wireless test method for a battery according to an embodiment of the present application;
FIG. 12 is a schematic flowchart of still another wireless test method for a battery according to an embodiment of the present application;
FIG. 13 is a schematic diagram of a test of a semi-finished battery according to an embodiment of the present application; and
FIG. 14 is a schematic diagram of a test of a finished battery according to an embodiment of the present application.

### Detailed Description of Embodiments

Embodiments of the technical solutions of the present application will be described in detail below with reference to the accompanying drawings. The following embodiments are merely intended to more clearly illustrate the technical solutions of the present application, so they merely serve as examples, but are not intended to limit the scope of protection of the present application.

Unless otherwise defined, all technical and scientific terms used herein have the same meanings as those commonly understood by those skilled in the art to which the present application belongs. The terms used herein are merely for the purpose of describing specific embodiments, but are not intended to limit the present application. The terms "including" and "having" and any variations thereof in the description and the claims of the present application as well as the brief description of the accompanying drawings described above are intended to cover non-exclusive inclusion.

In the description of the embodiments of the present application, the technical terms "first", "second", etc. are merely used for distinguishing different objects, and are not to be construed as indicating or implying relative importance or implicitly indicating the number, particular order or primary-secondary relationship of the indicated technical features. In the description of the embodiments of the present application, the phrase "a plurality of" means two or more, unless otherwise explicitly and specifically defined.

The phrase "embodiment" mentioned herein means that the specific features, structures, or characteristics described in conjunction with the embodiment can be encompassed in at least one embodiment of the present application. The phrase at various locations in the description does not necessarily refer to the same embodiment, or an independent or alternative embodiment exclusive of another embodiment. Those skilled in the art understand explicitly or implicitly that the embodiment described herein may be combined with another embodiment.

In the description of the embodiments of the present application, the term "and/or" is merely intended to describe the associated relationship of associated objects, indicating that three relationships can exist, for example, A and/or B can include: only A exists, both A and B exist, and only B exists. In addition, the character "/" herein generally indicates an "or" relationship between the associated objects.

In the description of the embodiments of the present application, the term "a plurality of" means two or more (including two), similarly the term "a plurality of groups" means two or more groups (including two groups), and the term "a plurality of pieces" means two or more pieces (including two pieces).

In the description of the embodiments of the present application, the orientation or position relationship indicated by the technical terms "central", "longitudinal", "transverse", "length", "width", "thickness", "upper", "lower", "front"; "rear", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are merely intended to facilitate and simplify the description of the embodiments of the present application, rather than indicating or implying that the apparatus or element considered must have a particular orientation or be constructed and operated in a particular orientation, and therefore not to be construed as limiting the embodiments of the present application.

In the description of the embodiments of the present application, unless otherwise explicitly specified and defined, the technical terms such as "install", "couple", "connect", and "fix" should be understood in a broad sense, for example, they may be a fixed connection, a detachable connection, or an integrated connection; may be a mechanical connection or an electric connection; and may be a direct connection or an indirect connection by means of an intermediate medium, or may be communication between interiors of two elements or interaction between the two elements. For those of ordinary skill in the art, the specific meanings of the above terms in the embodiments of the present application can be understood according to specific situations.

At present, from the perspective of the development of the market situation, traction batteries are used more and more widely. The traction batteries are not only used in energy storage power systems such as hydroelectric power plants, thermal power plants, wind power plants and solar power plants, but also widely used in electric transportation means such as electric bicycles, electric motorcycles, and electric vehicles and in many fields such as military equipment and aerospace. With the continuous expansion of the application field of traction batteries, the market demand for the traction batteries is also expanding.

A production process of a traction battery includes a test process. When the traction battery arrives at a test station corresponding to the test process, a test of the traction battery starts before the battery is off the production line, to ensure that the quality of the traction battery that leaves the factory meets the requirements. Currently, an end of line (EOL) comprehensive test system is used to test the traction battery off the production line. The EOL comprehensive test system integrates various functions such as a battery charge and discharge test, a battery safety test, a battery parameter test, a BMS test, and an auxiliary function test into a device, and uses methods of barcode binding, autostart testing, and automatic determining of test results to implement the full intelligence and automation of the entire workflow, so as to reduce operators and improve the test efficiency.

The inventors have noticed that since there are many test items for a test before being off the production line, a test cycle of each traction battery on the test station is relatively long, which brings about the problem of low test efficiency. To meet the cycle requirements of the entire production line, it is necessary to reserve more test stations when building the production line.

To solve the foregoing problem of low test efficiency of the battery, the inventors of the present application have found that among a plurality of test items, some test items can implement a wireless test, that is, the test can be implemented through wireless communication between a battery under test and a test terminal, and the battery under test does not need to be electrically connected to a test probe on the test station before starting the test.

In view of above, the embodiments of the present application provide a communication module and a wireless test system and method for a battery. The communication module can implement the wireless communication between the test terminal and the battery under test, and can perform a wireless test on the battery under test. Therefore, after the battery under test is in a test condition, a wireless test can be performed in any process before being off the production line, thereby reducing test items of the battery under test on test station, shortening a test time for the battery under test on the test station, and improving the test efficiency.

The wireless test system for a battery provided in the embodiments of the present application can be used to test a battery on a power consuming apparatus before leaving the factory, for example, to test a battery in a semi-finished state, or to test the finished battery before the battery is off the production line, or to test the battery before shipment and to test the battery after sale. The power consuming apparatus may be, but is not limited to, a mobile phone, a tablet, a notebook computer, an electric toy, a power tool, a battery cart, an electric vehicle, a ship, a spacecraft, etc. The electric toy may include a stationary or mobile electric toy, such as a game console, an electric vehicle toy, an electric ship toy, and an electric airplane toy. The spacecraft may include an airplane, a rocket, a space shuttle, a spaceship, etc.

In addition, the battery under test described in the embodiments of the present application can be understood as a traction battery or a battery pack.

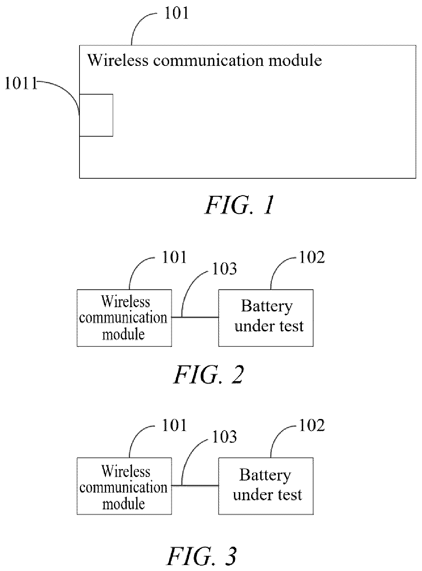

FIG. 1 is a schematic diagram of a structure of a first type of communication module according to an embodiment of the present application. As shown in FIG. 1, the communication module 101 includes a wireless communication interface (not shown in the figure) and a wired communication interface 1011.

The communication module 101 is in wireless communication connection to a test terminal through the wireless communication interface, and is connected to a battery under test through the wired communication interface. The communication module 101 is configured to receive instruction data sent by the test terminal, and send a test instruction corresponding to the instruction data to the battery under test. The test instruction is sent to the communication module 101 by the test terminal after establishing a wireless communication connection to the communication module 101. It should be noted that data transmission between the communication module 101 and the test terminal may be performed through wireless communication, and in this case, the communication module 101 is a wireless communication module.

The battery under test generates a corresponding battery parameter according to the test instruction, and sends the battery parameter to the communication module 101.

After receiving the battery parameter, the communication module 101 returns test data corresponding to the battery parameter to the test terminal, and the test terminal generates a test result based on the test data.

The communication module 101 may be a module supporting GPRS and short message service dual-channel data transmission, and multi-center data communication. The module can acquire data from a serial device (for example, a battery under test). The communication module 101 may be a DATA-6106 communication module, or other types of communication modules. In practical applications, the module can be selected according to actual situations, which is not specifically limited in this embodiment of the present application.

It can be understood that the communication module 101 can establish a wireless communication connection to the test terminal through the wireless communication interface, and methods of wireless data transmission include but are not limited to WiFi, 5G, Bluetooth, ZigBee, near field communication (NFC), and ultra wide band (UWB).

After the communication module 101 establishes a wireless communication connection to the test terminal, the test terminal may send instruction data to the communication module 101. The instruction data is an instruction for testing the battery under test, and may be generated according to a test case preconfigured in the test terminal. It can be understood that test items corresponding to different types of batteries may be different, so that test cases corresponding to the test items are also different, and then test instructions corresponding to the test items are also different.

The communication module 101 is connected to the battery under test through the wired communication interface 1011. It can be understood that wired connection between the communication module 101 and the battery under test can be wire connection that can be used for data transmission; or the wired communication interface 1011 may be a male interface, and can be inserted into the battery under test through physical contact; or the battery under test includes a male interface, and the wired communication interface 1011 is a female interface matching the male interface, and the battery under test can be inserted into the communication module 101 through physical contact. After receiving the instruction data sent by the test terminal, byte conversion is performed on the instruction data, for example: the instruction data includes 20-byte data, and the communication module 101 parses the received 20-byte data to obtain 1 ID and 8-byte data. It can be understood that the 1 ID and 8-byte data constitute the test instruction, and the test instruction is sent to the battery under test. It can be understood that the above is only an example, and specific content contained in the instruction data sent by the test terminal to the communication module 101 may be determined according to actual situations. In some embodiments, the communication module 101 can only perform signal type conversion on the instruction data without any modification to content of the instruction data. In this case, it can be understood that the instruction data sent by the test terminal and received by the communication module 101 is the same as the test instruction sent to the battery under test. After receiving the test instruction, the battery under test sends the corresponding battery parameter to the communication module 101. For example, the test instruction may be an instruction to test a minimum voltage of the battery under test, and the battery under test sends the recorded minimum voltage of the battery under test as a battery parameter to the communication module 101 after receiving the test instruction. For example, the battery parameter includes 1 ID and an 8-byte parameter, and the communication module 101 converts the received ID into a new byte that forms new 20-byte test data with the received 8-byte parameter, and then sends the test data to the test terminal. It can be understood that the above is only an example, and specific content contained in the battery parameter sent by the battery under test to the communication module 101 may be determined according to actual situations. In some embodiments, the communication module 101 can only perform signal type conversion on the battery parameter without any modification to content of the battery parameter. In this case, it can be understood that the battery parameter sent by the battery under test and received by the communication module 101 is the same as the test data sent to the test terminal.

After receiving the battery parameter, the communication module 101 sends the test data corresponding to the battery parameter to the test terminal, and the test terminal can check the test data to determine whether the battery under test meets the requirements under the test item.

It can be understood that a standard parameter corresponding to each test item that represents that a battery meets the requirements is preset in test software in the test terminal. The standard parameter may be in the form of a numerical range, a specific numerical value, a Boolean value, etc., and may be determined based on a test item, which is not specifically limited in this embodiment of the present application. After receiving the test data, the test terminal matches the test data with the standard parameter. If the test data matches the standard parameter, it indicates that the battery under test has passed the test for the corresponding test item; otherwise, it indicates that the battery under test has not passed the test for the corresponding test item. Still taking the test item being testing a minimum voltage as an example, a value range of a minimum voltage stored in the test terminal is [19 V, 20 V],and if a minimum voltage in the test data is 19.5 V, 19.5 V is within the value range of the foregoing minimum voltage. In this way, the battery under test passes the test for this test item.

This embodiment of the present application implements the test of the battery under test through wireless communication, where test items that can be implemented through wireless testing can be implemented before the battery under test arrives at a test station or after the battery under test leaves the test station. This reduces test items on the test station, shortens the test cycle on the test station, and improves the test efficiency. In addition, the system provided in this embodiment of the present application can also perform a test in parallel with a wired test on the test station, which improves the test efficiency.

In a configuration not forming part of the invention, the battery under test may be connected to the wired communication interface through a wire harness.

In a specific implementation process not forming part of the invention, FIG. 2 is a schematic diagram of a communication module being connected to a battery under test not having a wireless communication function. The battery under test 102 not having a wireless communication function may be connected to the communication module 101 through a wire harness 103, so as to implement a function of mutual communication with the test terminal. The wire harness 103 is a wire that can connect the battery under test 102 and the communication module 101. One end of the wire harness 103 is connected to the communication module 101, and the other end of the wire harness 103 can include at least one interface, which is connected to the battery under test 102 in a removable manner. It can be understood that, when the other end of the wire harness 103 includes a plurality of interfaces, the plurality of interfaces can match different types of batteries under test 102, so that the batteries under test 102 that are connected can be quickly swapped.

During a test, the wire harness 103 is first separately connected to the communication module 101 and the battery under test 102, the communication module 101 receives instruction data of the test terminal, and sends a test instruction corresponding to the received instruction data to the battery under test 102. The battery under test 102 sends a battery parameter corresponding to the test instruction to the communication module 101, the communication module 101 returns test data corresponding to the battery parameter to the test terminal, and the test terminal detects the test data.

It can be understood that after generating a test result, the test terminal may further upload the test result to a manufacturing execution system (MES).

In this configuration not forming part of the invention, the battery under test is connected to the communication module through a wire harness. A wireless test for some test items of the battery under test can be implemented without changing a structure of the battery under test, and therefore, a wired test does not need to be performed for these test items again on the test station. This shortens the test cycle on the test station and improves the test efficiency.

The communication module is integrated into the battery under test.

In a specific implementation process, FIG. 3 is a schematic diagram of a battery under test having a wireless communication function being connected to a communication module according to an embodiment of the present application. The communication module 101 is integrated into the battery under test 102. The battery under test 102 is communicatively connected to the test terminal through the communication module.

After the battery under test 102 is powered on and is woken up, a communication connection is established to the test terminal through the communication module. The test terminal sends a test instruction to the battery under test 102 through the communication module, and the battery under test 102 generates a battery parameter corresponding to the test instruction, and sends test data corresponding to the battery parameter to the test terminal through the communication module 101. The test terminal analyzes and determines the test data to generate a test result.

It can be understood that after generating a test result, the test terminal may further upload the test result to a manufacturing execution system (MES).

The communication module is integrated into the battery under test, so that the battery under test has a wireless communication function. Then, a wireless test for some test items of the battery under test can be implemented, and therefore, a wired test does not need to be performed for these test items again on the test station. This shortens the test cycle on the test station and improves the test efficiency.

On the basis of the foregoing embodiment, the communication module includes a signal conversion module configured to convert a signal type of the instruction data into a signal type suitable for the battery under test, and send, to the battery under test, a test instruction obtained after the conversion.

In a specific implementation process, the signal conversion module is a module that uses a wireless signal as a relay medium. For example, WiFi may be used as a signal medium, or a 4G network, a 5G network, or Bluetooth may be used as a signal medium. Specifically, a corresponding signal conversion module may be selected based on a wireless communication manner in practical applications. The signal conversion module may be a CAN-to-WiFi module, a CAN-to-Bluetooth module, a CAN-to-5G module, etc.

A function of the signal conversion module is to receive instruction data sent by the test terminal through a wireless signal, convert a signal type of the instruction data into a signal type that the battery under test can recognize, and send, to the battery under test, a test instruction obtained after the conversion. For example, CAN data is converted into WiFi data. In addition, the signal conversion module is further configured to receive test data corresponding to the test instruction and returned by the battery under test, and return the test data to the test terminal.

In this embodiment of the present application, the communication module includes the signal conversion module that can convert the signal type of the instruction data sent by the test terminal into a signal type recognizable by the battery under test, thereby ensuring the smooth execution of a wireless test process.

On the basis of the foregoing embodiment, the communication module further includes a first controller, where the first controller is configured to receive a first channel switching instruction sent by the test terminal, and control, according to the first channel switching instruction, the signal conversion module to perform channel switching.

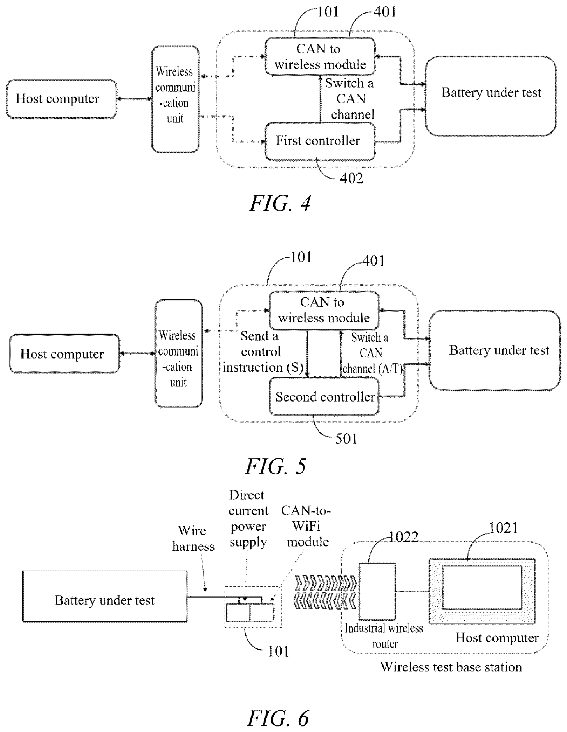

In a specific implementation process, FIG. 4 is a schematic diagram of a structure of a second type of communication module according to an embodiment of the present application. The communication module 101 includes a signal conversion module 401 and a first controller 402, where the first controller 402 is integrated with a wireless to serial port, and the wireless to serial port provides the first controller 402 to receive the first channel switching instruction sent by the test terminal. The test terminal includes a host computer and a wireless communication unit. For example, the test terminal includes three CAN interfaces, which are respectively a CAN1 interface, a CAN2 interface, and a CAN3 interface, and the communication module 101 includes two CAN interfaces, which are respectively a CAN4 interface and a CAN5 interface. The CAN4 interface is kept connected to the CAN1 interface, and the CAN5 interface can only be connected to the CAN2 interface or the CAN3 interface at the same time. If the CAN5 interface is connected to the CAN2 interface at a current moment, and the test terminal needs to send instruction data to the communication module 101 through the CAN3 interface, the test terminal sends the first channel switching instruction to the first controller 402 before sending the instruction data. It can be understood that the first controller 402 is integrated with a wireless to serial port function, through which a switching instruction sent by the test terminal can be received, and the switching instruction can be converted into serial port data. The first controller 402 controls the signal conversion module to perform channel switching based on the serial port data, that is, connects the CAN5 interface and the CAN3 interface. After the channel switching is completed, the test terminal can send instruction data to the signal conversion module, so as to implement a test of the battery under test.

In addition, the first controller 402 can further assist the battery under test in completing the test. For example, in some instruction data sent by the test terminal, the first controller is required to control a circuit drawn from the circuit inside the battery under test. For example, the instruction data is to connect a specific resistor, and the test terminal sends the instruction data to the first controller, and after receiving the instruction data, the first controller connects the resistor to the circuit drawn from the inside of the battery under test.

Since different test items require different wireless channels, when a number of channels is insufficient, channel switching is performed through the first controller, thereby implementing a wireless test of the battery under test, reducing test items for a wired test of the battery under test on the test station, and improving the test efficiency.

On the basis of the foregoing embodiment, the communication module further includes a second controller, where
the signal conversion module is further configured to receive a second channel switching instruction sent by the test terminal, and send the second channel switching instruction to the second controller; and
the second controller controls, according to the second channel switching instruction, the signal conversion module to perform channel switching.

In a specific implementation process, FIG. 5 is a schematic diagram of a structure of a third type of communication module according to an embodiment of the present application. The communication module 101 includes a signal conversion module 401 and a second controller 501, where a chip that can receive a CAN signal is integrated into the second controller 501, and the chip is configured to receive a second channel switching instruction sent by the signal conversion module 401. The signal conversion module 401 receives a second channel switching instruction sent by the test terminal. The test terminal includes a host computer and a wireless communication unit. For example, the test terminal includes three CAN channels, which are respectively a CAN1 interface, a CAN2 interface, and a CAN3 interface, and the communication module 101 includes two CAN channels, which are respectively a CAN4 interface and a CAN5 interface. The CAN4 interface is kept connected to the CAN1 interface, and the CAN5 interface can only be connected to the CAN2 interface or the CAN3 interface at the same time. If the CAN5 interface is connected to the CAN2 interface at a current moment, and the test terminal needs to send instruction data to the communication module 101 through the CAN3 interface, the test terminal sends the second channel switching instruction to the second controller 501 before sending the instruction data. It can be understood that the signal conversion module 401 may receive the second channel switching instruction through the CAN1 interface and the CAN4 interface, and send the second channel switching instruction to the second controller 501. The second controller 501 controls the signal conversion module 401 to perform channel switching after receiving the second channel switching instruction, that is, connects the CAN5 interface and the CAN3 interface. After the channel switching is completed, the test terminal can send instruction data to the signal conversion module 401, so as to implement a test of the battery under test.

In addition, the second controller 501 can further assist the battery under test in completing the test. For example, in some instruction data sent by the test terminal, the second controller 501 is required to control a circuit drawn from the circuit inside the battery under test. For example, the instruction data represents disconnecting or connecting a specific resistor, and the test terminal sends the instruction data to the second controller 501, and after receiving the instruction data, the second controller 501 disconnects or connects a corresponding resistor.

Since different test items require different wireless channels, when a number of channels is insufficient, channel switching is performed through the second controller, thereby implementing a wireless test of the battery under test, reducing test items for a wired test of the battery under test on the test station, and improving the test efficiency.

On the basis of the foregoing embodiment, the communication module further includes a power supply, where the power supply is configured to power the battery under test.

In a specific implementation process, the power supply may be a direct current power supply, and can also power the battery under test while providing electrical energy for the communication module. FIG. 6 is a diagram of a structure of a fourth type of communication module according to an embodiment of the present application. The communication module 101 includes a signal conversion module and a direct current power supply, and the communication module is electrically connected to the battery under test through a wire harness. The signal conversion module may be specifically a CAN-to-WiFi module. The test terminal includes a host computer 1021 and an industrial wireless router 1022. After connecting the wire harness to the battery under test, the direct current power supply powers the battery under test. The battery under test sends CAN data. It can be understood that the CAN data may include verification information, which is used to represent identity information of the battery under test, for example, a barcode of the battery under test. The CAN data is transferred to the CAN-to-WiFi module through the wire harness. The CAN-to-WiFi module converts the received CAN data into WiFi data, and transfers the WiFi data to the industrial wireless router. The industrial wireless router transfers the received WiFi data to the host computer, and the host computer determines the WiFi data to determine an identity of the battery under test based on verification information in the WiFi data. The CAN data including instruction data sent by the host computer is converted into WiFi data including a test instruction through the industrial wireless router, and the WiFi data is then transferred to the CAN-to-WiFi module. The CAN-to-WiFi module converts the received WiFi data including instruction data into CAN data including a test instruction, and transfers the CAN data to the battery under test. The battery under test generates corresponding test data based on the received CAN data including a test instruction, and sends the test data to the test terminal through the CAN-to-WiFi module, and the test terminal analyzes the test data to complete the test.

It can be understood that, for a case of a plurality of test items, instruction data sent by the test terminal may include all test items, or only one test item. For a case of including one test item, a plurality of interactions between the test terminal and the battery under test in the foregoing process can be used to implement a test for a plurality of test items.

In this embodiment of the present application, the communication module powers a low-voltage circuit of the battery under test, so that the battery under test can be woken up through the power supply, and the communication module can obtain the battery parameter of the battery under test, to complete a wireless test.

In another embodiment, a signal conversion module, a direct current power supply, and a controller may be further integrated into the communication module. It can be understood that for corresponding functions of the signal conversion module, the direct current power supply, and the controller, reference may be made to the foregoing embodiment, and details are not repeated here.

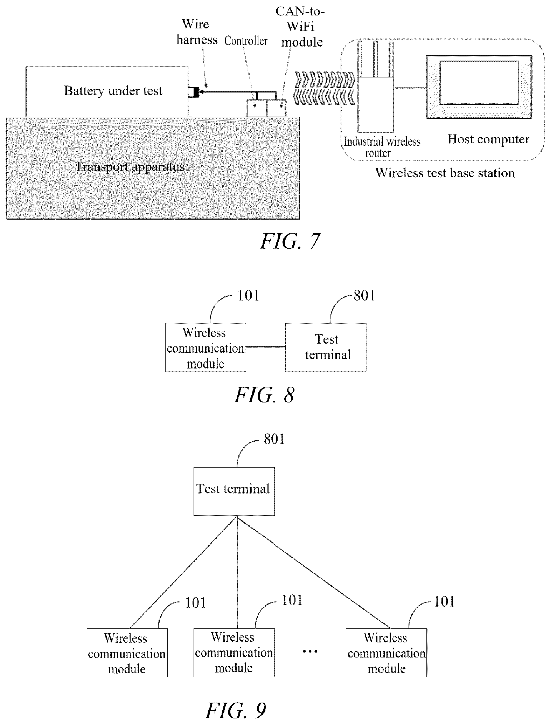

In another embodiment, for a case where the communication module includes a signal conversion module and a controller, the communication module can be powered by an external device. FIG. 7 is a schematic diagram of a structure of a communication module powered by an external device according to an embodiment of the present application. As shown in FIG. 7, the external device may be a transport apparatus, and may be specifically an AGV trolley for transporting a battery under test. A test method of the battery under test is as follows: After a wire harness is connected to the battery under test, the controller switches a relay to connect the battery under test to the transport apparatus, and the transport apparatus starts to power the battery under test. The battery under test sends CAN data. It can be understood that the CAN data may include verification information, which is used to represent identity information of the battery under test, for example, a barcode of the battery under test. The CAN data is transferred to the CAN-to-WiFi module through the wire harness. The CAN-to-WiFi module converts the received CAN data into WiFi data, and transfers the WiFi data to the industrial wireless router. The industrial wireless router transfers the received WiFi data to the host computer, and the host computer determines the WiFi data to determine an identity of the battery under test based on verification information in the WiFi data. The CAN data (that is, instruction data) sent by the host computer is converted into WiFi data through the industrial wireless router, and the WiFi data is then transferred to the CAN-to-WiFi module. The CAN-to-WiFi module converts the received WiFi data into CAN data, and transfers CAN data for the battery under test to the battery under test. The battery under test generates a corresponding battery parameter based on the received CAN data, and sends the battery parameter to the test terminal through the CAN-to-WiFi module. The CAN-to-WiFi module sends CAN data for the controller to the controller, so that the controller can switch CAN channels or test different functions.

On the basis of the foregoing embodiment, the foregoing test instruction includes at least one of a BMS master control test instruction, a BMS slave control test instruction, a minimum voltage test instruction, a maximum voltage test instruction, a minimum temperature test instruction, a maximum temperature test instruction, an SOC detection instruction, an interlock signal fault detection instruction, a slow charging function detection instruction, and a fast charging function detection instruction.

In the specific implementation process, the BMS master control test instruction is used to detect whether a power supply function or a communication function of BMS master control in the battery under test is normal, and is used to obtain a software version of the BMS master control in the battery under test to determine whether the software version is the same as a standard version in the test terminal.

The BMS slave control test instruction is used to detect a power supply function and a communication function of BMS slave control in the battery under test, and whether connection of the BMS slave control is normal.

The minimum voltage test instruction is used to acquire a minimum voltage of the battery under test to detect whether the minimum voltage is within a preset minimum voltage range.

The maximum voltage test instruction is used to acquire a maximum voltage of the battery under test to detect whether the maximum voltage is within a preset maximum voltage range.

The minimum temperature test instruction is used to acquire a minimum temperature of the battery under test to detect whether the minimum temperature is within a preset minimum temperature range.

The maximum temperature test instruction is used to acquire a maximum temperature of the battery under test to detect whether the maximum temperature is within a preset maximum temperature range.

The SOC detection instruction is used to acquire an SOC value of the battery under test to detect whether the SOC value is within a preset SOC range.

The interlock signal fault detection instruction controls connection or disconnection of an interlock signal line and sends a corresponding state of the BMS to the test terminal through the communication module to detect whether an interlock signal is faulty.

The slow charging function detection instruction uses an external enable signal CC and a CP signal to detect whether a slow charging function is normal.

The fast charging function detection instruction uses an external enable signal CC2 to detect whether a fast charging function is normal.

In this embodiment of the present application, for the foregoing test items that can be completed through wireless communication, data interaction between the battery under test and the test terminal is implemented by using the communication module, to complete the wireless test, thereby reducing test items for a wired test of the battery under test on the test station, and improving the test efficiency.

FIG. 8 is a schematic diagram of a structure of a wireless test system for a battery according to an embodiment of the present application. As shown in FIG. 8, the system includes a test terminal 801 and the communication module 101 described in the foregoing embodiments.

In a specific implementation process, the test terminal 801 may be a terminal having a wireless communication function, for example, a smart phone, a tablet computer, a computer, and a personal digital assistant (PDA). Therefore, the test terminal 801 further includes a wireless communication function unit. Certainly, the test terminal 801 may be alternatively a terminal not having a wireless communication function, such as a computer not having a wireless communication function. The test terminal 801 not having a wireless communication function can implement communication connection to the communication module 101 through an external wireless communication unit, as shown in FIG. 7. The host computer in FIG. 7 communicates with the battery under test through the industrial wireless router. In the test terminal, test software may be preinstalled, and the test software is pre-configured with test cases for various test items for the wireless test of the battery under test. It can be understood that the test cases for various test items may be independent, or may be a complete test case combined according to a specific test sequence.

For a specific structure and functions of the communication module 101, reference may be made to the foregoing embodiments, and details are not repeated here.

In this embodiment of the present application, the communication module is in wireless communication connection to the test terminal, so that a wireless test of the battery under test can be implemented, thereby reducing test items for a wired test on the test station, shortening the test cycle on the test station, and improving the test efficiency.

On the basis of the foregoing embodiment, there are a plurality of communication modules, and the test terminal is configured to wirelessly test a plurality of batteries under test by using the plurality of communication modules.

In a specific implementation process, FIG. 9 is a schematic diagram of a structure of another wireless test system for a battery according to an embodiment of the present application. The test terminal can be understood as a wireless test base station, which can communicate with a plurality of communication modules, so as to implement a wireless test of a plurality of batteries under test at the same time.

In this embodiment of the present application, the plurality of batteries under test can be tested through communication connection between the test terminal and a plurality of communication modules, thereby improving the test efficiency.

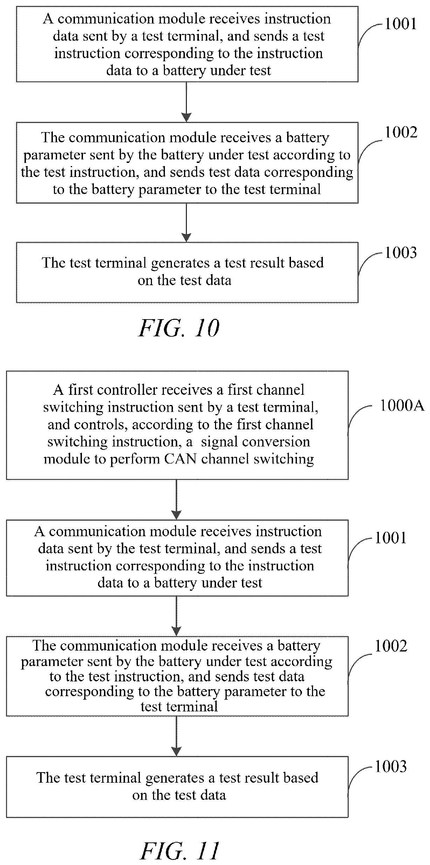

FIG. 10 is a schematic flowchart of a wireless test method for a battery according to an embodiment of the present application. As shown in FIG. 10, it can be understood that the method can be applied to the wireless testing system for a battery in the foregoing embodiments, and the method includes the following steps:
step 1001: a communication module receives instruction data sent by a test terminal, and sends a test instruction corresponding to the instruction data to a battery under test;
step 1002: the communication module receives a battery parameter sent by the battery under test according to the test instruction, and sends test data corresponding to the battery parameter to the test terminal; and
step 1003: the test terminal generates a test result based on the test data.

In step 1001, for the related introduction of the communication module, reference may be made to the foregoing embodiments, and details are not repeated here. After the communication module establishes a wireless communication connection to the test terminal, and methods of wireless data transmission include but are not limited to WiFi, 5G, Bluetooth, ZigBee, near field communication (NFC), and ultra wide band (UWB).

The test terminal may send instruction data to the communication module. The instruction data is data for testing the battery under test, and may be generated according to a test case preconfigured in the test terminal. It can be understood that test items corresponding to different types of batteries may be different, so that test cases corresponding to the test items are also different, and then instruction data corresponding to the test items is also different.

In step 1002, after receiving the instruction data sent by the test terminal, the communication module sends the test instruction corresponding to the instruction data to the battery under test; the battery under test generates the battery parameter corresponding to the test instruction after receiving the test instruction, and sends the battery parameter to the communication module; and the communication module returns the test data corresponding to the battery parameter to the test terminal.

In step 1003, a standard parameter corresponding to each test item that represents that a battery meets the requirements is preset in test software in the test terminal. The standard parameter may be in the form of a numerical range, a specific numerical value, a Boolean value, etc., and may be determined based on a test item, which is not specifically limited in this embodiment of the present application. After receiving the test data, the test terminal matches the test data with the standard parameter. If the test data matches the standard parameter, it indicates that the battery under test has passed the test for the corresponding test item; otherwise, it indicates that the battery under test has not passed the test for the corresponding test item. Still taking the test item being testing a minimum voltage as an example, a value range of a minimum voltage stored in the test terminal is [19 V, 20 V], and if a minimum voltage in the test data is 19.5 V, 19.5 V is within the value range of the foregoing minimum voltage. In this way, the battery under test passes the test for this test item.

This embodiment of the present application implements the test of the battery under test through wireless communication, where test items that can be implemented through wireless testing can be implemented before the battery under test arrives at a test station or after the battery under test leaves the test station. This reduces test items on the test station, shortens the test cycle on the test station, and improves the test efficiency. In addition, the system provided in this embodiment of the present application can also perform a test in parallel with a wired test on the test station, which improves the test efficiency.

The communication module is integrated into the battery under test. Alternatively, the communication module may be connected to the battery under test through a wire harness, although this configuration is not part of the invention.

In a specific implementation process not forming part of the invention, the battery under test that does not have a wireless communication function may be connected to the communication module through the wire harness, so that wireless communication with a battery under test can be implemented through the communication module, to implement the wireless test process of steps 1001 to 1003 above.

In a production process of the battery under test, the communication module is integrated into the battery under test, so that the produced battery under test has a wireless communication function. Therefore, wireless communication with the battery under test can be implemented through the communication module integrated into the battery under test, to implement the wireless test process of steps 1001 to 1003 above.

In a configuration not forming part of the invention, the battery under test may be connected to the communication module through a wire harness. A wireless test for some test items of the battery under test can be implemented without changing a structure of the battery under test, and therefore, a wired test does not need to be performed for these test items again on the test station. This shortens the test cycle on the test station and improves the test efficiency.

The communication module is integrated into the battery under test, so that the battery under test has a wireless communication function. Thus, a wireless test for some test items of the battery under test can be implemented, and therefore, a wired test does not need to be performed for these test items again on the test station. This shortens the test cycle on the test station and improves the test efficiency.

On the basis of the foregoing embodiment, the communication module includes a signal conversion module and a first controller; and both the signal conversion module and the first controller are communicatively connected to the test terminal. FIG. 11 is a schematic flowchart of another wireless test method for a battery according to an embodiment of the present application. As shown in FIG. 11, the method includes the following steps:
step 1000A: the first controller receives a first channel switching instruction sent by the test terminal, and controls, according to the first channel switching instruction, the signal conversion module to perform CAN channel switching;
step 1001: the communication module receives instruction data sent by the test terminal, and sends a test instruction corresponding to the instruction data to the battery under test;
step 1002: the communication module receives a battery parameter sent by the battery under test according to the test instruction, and sends test data corresponding to the battery parameter to the test terminal; and
step 1003: the test terminal generates a test result based on the test data.

In step 1000A, when the test terminal detects that a number of CAN channels is insufficient, that is, a number of CAN interfaces of the test terminal used to transmit instruction data is greater than a number of CAN interfaces in the communication module, an unconnected CAN interface may be left in the test terminal. For example, the test terminal includes three CAN interfaces, which are respectively a CAN1 interface, a CAN2 interface, and a CAN3 interface, and the communication module 101 includes two CAN interfaces, which are respectively a CAN4 interface and a CAN5 interface. The CAN4 interface is kept connected to the CAN1 interface, and the CAN5 interface can only be connected to the CAN2 interface or the CAN3 interface at the same time. If the CAN5 interface is connected to the CAN2 interface at a current moment, and the test terminal needs to send instruction data to the communication module through the CAN3 interface, the test terminal sends the first channel switching instruction to the first controller before sending the instruction data. It can be understood that the first controller is integrated with a wireless to serial port function, through which a switching instruction sent by the test terminal can be received, and the switching instruction can be converted into serial port data. The first controller controls the signal conversion module to perform channel switching based on the serial port data, that is, connects the CAN5 interface and the CAN3 interface. After the channel switching is completed, the test terminal can send instruction data to the signal conversion module, so as to implement a test of the battery under test. It can be understood that, for a specific implementation of steps 1001 to 1003, reference may be made to the foregoing embodiments, and details are not repeated here.

Since different test items require different wireless channels, when a number of channels is insufficient, channel switching is performed through the first controller, thereby implementing a wireless test of the battery under test, reducing test items for a wired test of the battery under test on the test station, and improving the test efficiency.

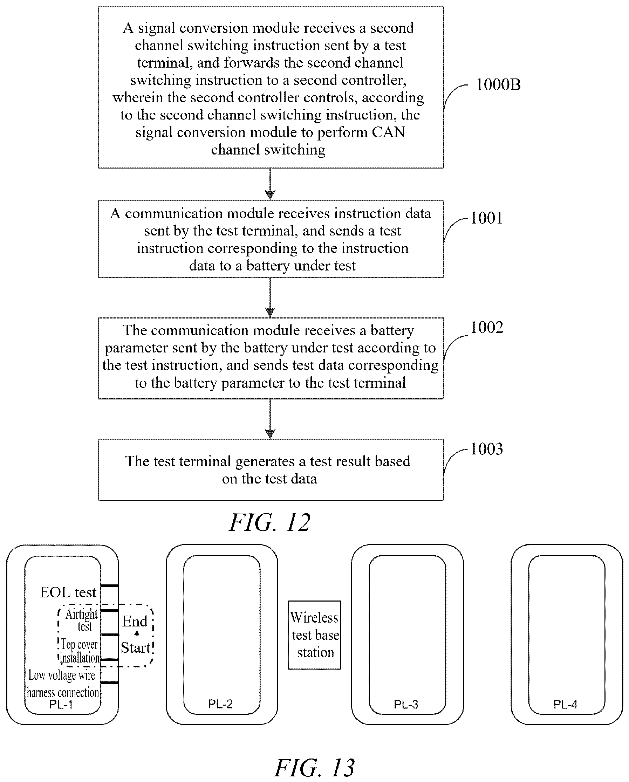

On the basis of the foregoing embodiment, the communication module includes a signal conversion module and a second controller; and the signal conversion module is communicatively connected to the test terminal. FIG. 12 is a schematic flowchart of still another wireless test method for a battery according to an embodiment of the present application. As shown in FIG. 12, the method includes the following steps:
step 1000B: The signal conversion module receives a second channel switching instruction sent by the test terminal, and forwards the second channel switching instruction to the second controller, where the second controller controls, according to the second channel switching instruction, the signal conversion module to perform CAN channel switching.
step 1001: the communication module receives instruction data sent by the test terminal, and sends a test instruction corresponding to the instruction data to the battery under test;
step 1002: the communication module receives a battery parameter sent by the battery under test according to the test instruction, and sends test data corresponding to the battery parameter to the test terminal; and
step 1003: the test terminal generates a test result based on the test data.

In a specific implementation process, referring to FIG. 5, the communication module includes a signal conversion module and a second controller, where a chip that can receive a CAN signal is integrated into the second controller, and the chip is configured to receive a second channel switching instruction sent by the signal conversion module. When the test terminal detects that a number of CAN channels is insufficient, that is, a number of CAN interfaces of the test terminal used to transmit instruction data is greater than a number of CAN interfaces in the communication module, an unconnected CAN interface may be left in the test terminal. It can be understood that the unconnected CAN interface is not connected to a CAN interface in the communication module to form a CAN channel, and therefore, instruction data cannot be sent through the unconnected CAN interface. However, when the instruction data needs to be sent through the unconnected CAN interface, the unconnected CAN interface needs to be connected to the CAN interface in the communication module. Then, the test terminal can send a switching instruction to the signal conversion module through an established CAN channel, and the signal conversion module sends the switching instruction to the second controller. After receiving the second channel switching instruction, the second controller controls the signal conversion module to perform channel switching. After the channel switching is completed, the test terminal can send instruction data to the signal conversion module, so as to implement a test of the battery under test.

It can be understood that, for a specific implementation of steps 1001 to 1003, reference may be made to the foregoing embodiments, and details are not repeated here.

Since different test items require different wireless channels, when a number of channels is insufficient, channel switching is performed through the second controller, thereby implementing a wireless test of the battery under test, reducing test items for a wired test of the battery under test on the test station, and improving the test efficiency.

On the basis of the foregoing embodiment, before the battery under test arrives at a test station, a test process corresponding to the method is completed.

On the basis of the foregoing embodiment, FIG. 13 is a schematic diagram of a test of a semi-finished battery according to an embodiment of the present application. In a production process of a battery, a top cover installation station and an airtight test station are located before an EOL test station. Therefore, the battery wireless test method process described above may be performed between the top cover installation station and the airtight test station of the battery under test. The test terminal may be regarded as a wireless test base station. The test terminal includes an industrial wireless router and a host computer. According to different models, the industrial wireless router can establish connection to different numbers of communication modules at the same time to implement data interaction. Communication between the industrial wireless router and each communication module is independent of each other and does not interfere with each other. Taking product production lines in the same workshop as an example, a wireless test of PL-1 to PL-4 can be completed by one test base station. Taking a battery under test not having a wireless communication function as an example, a specific test method process of the battery under test is as follows:

In step 1, after connection between the wire harness and the battery under test is completed, a transport apparatus carries a product under test to the top cover installation station. The transport apparatus may be an AGV trolley or a transport robot, which is not specifically limited in this embodiment of the present application.

In step 2, while a wireless test is performed, a top cover starts to be installed.

In step 3, when the top cover has been installed and an airtight test is completed, the work of the wireless test part has also been completed at this time. When airtight tools are removed, test wire harnesses are also removed.

In step 4, during an EOL test at the next station, test items that have been wirelessly performed before do not need to be performed again to achieve the effect of shortening the cycle.

In this embodiment of the present application, the wireless test process is controlled to be completed before the battery under test arrives at the test station, so that the battery under test only needs to be tested for other test items on the test station. This reduces a number of test items on the test station, and improves the test efficiency.

On the basis of the foregoing embodiment, after the battery under test leaves a test station, a test process corresponding to the method starts to be executed.

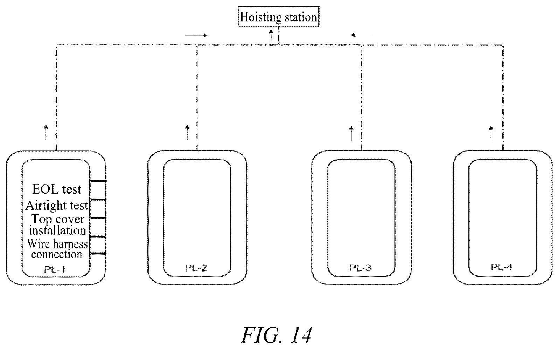

In a specific implementation process, FIG. 14 is a schematic diagram of a test of a finished battery according to an embodiment of the present application. In a production process of a battery, an EOL test station is located before a hoisting station. After test items other than the wireless test are completed on the EOL test station, the battery leaves the EOL test station, and the wireless test starts when the battery leaves the EOL test station. In a wireless test process, the transport apparatus performs a wireless test on the finished battery in a process of transporting the finished battery to the hoisting station. The wireless test is completed before the finished battery arrives at the hoisting station and the finished battery is hoisted.

It can be understood that if the wireless test process is not completed after the finished battery arrives at the hoisting station, the hoisting can be started after the wireless test process is completed.

In this embodiment of the present application, the wireless test process is controlled to start to be executed after the battery under test leaves the test station, so that the battery under test only needs to be tested for other test items on the test station. This reduces a number of test items on the test station, and improves the test efficiency.

On the basis of the foregoing embodiment, the test terminal sends the instruction data to the communication module after detecting that the battery under test has arrived at a preset station.

In the specific implementation process, the test terminal is communicatively connected to the transport apparatus that transports the battery under test. An identifier of the transport apparatus and a barcode of the transported battery under test are stored in the transport apparatus. The transport apparatus has a positioning function, and can send a location of the transport apparatus to the test terminal, so that the test terminal can monitor the location of the battery under test. When detecting that the battery under test has arrived at the preset station, the test terminal can send instruction data to the communication module to start the wireless test.

In this embodiment of the present application, a position of the battery under test is monitored through the test terminal, and a wireless test is started after the battery under test arrives at the preset station, so that some test items are performed through the wireless test, and a test time on the test station is not required, thereby improving the test efficiency.

On the basis of the foregoing embodiment, there are a plurality of communication modules, and each of the communication modules is connected to at least one battery under test.

In a specific implementation process not forming part of the invention, for a case where the communication module is connected to the battery under test through a wire harness, one end of the wire harness includes an interface connected to the communication module, and the other end of the wire harness includes at least one interface connected to the battery under test. It can be understood that when the other end of the wire harness includes a plurality of interfaces, each interface can be connected to one battery under test.

A plurality of communication modules may be wirelessly connected to the test terminal at the same time, so the test terminal can be understood as a wireless test base station.

In this embodiment of the present application, the plurality of batteries under test can be tested through communication connection between the test terminal and a plurality of communication modules, thereby improving the test efficiency.

On the basis of the foregoing embodiment, the foregoing test instruction includes at least one of a battery management system BMS master control test instruction, a BMS slave control test instruction, a minimum voltage test instruction, a maximum voltage test instruction, a minimum temperature test instruction, a maximum temperature test instruction, an SOC detection instruction, an interlock signal fault detection instruction, a slow charging function detection instruction, and a fast charging function detection instruction.

It can be understood that, for the specific description of the foregoing test instructions, reference may be made to the foregoing embodiments, and details are not repeated here.

In this embodiment of the present application, for the foregoing test items that can be completed through wireless communication, data interaction between the battery under test and the test terminal is implemented by using the communication module, to complete the wireless test, thereby reducing test items for a wired test of the battery under test on the test station, and improving the test efficiency.

In the embodiments provided in the present application, it should be understood that the disclosed apparatus and method can be implemented by other methods. The described apparatus embodiments are merely examples. For example, the unit division is merely logical function division and may be other division in actual implementation. For another example, a plurality of units or components may be combined or integrated into another system, or some features may be ignored or not performed. In addition, the displayed or discussed mutual couplings or direct couplings or communication connections may be implemented through some communication interfaces. The indirect couplings or communication connections between the apparatuses or units may be implemented in electronic, mechanical, or other forms.

Further, the units described as separate parts may or may not be physically separated, and parts displayed as units may or may not be physical units, that is, they may be located in one position, or may be distributed on a plurality of network units. Some or all of the units may be selected according to actual requirements to achieve the objectives of the solutions of the embodiments.

Furthermore, various functional modules in various embodiments of the present application may be integrated to form a separate part, or the modules may exist separately, or two or more modules may be integrated to form a separate part.

In the specification, relational terms such as first and second are used only to distinguish one entity or operation from another entity or operation, and do not necessarily require or imply that any actual relationship or sequence exists between these entities or operations.

## Claims

1. A communication module (101), comprising a wireless communication interface and a wired communication interface (1011), wherein
the communication module (101) is in wireless communication connection to a test terminal (801) through the wireless communication interface, and is configured to receive instruction data sent by the test terminal (801);
the communication module (101) is connected to a battery under test (102) through the wired communication interface (1011), and is configured to send a test instruction corresponding to the instruction data to the battery under test (102), and receive a corresponding battery parameter generated by the battery under test (102) according to the test instruction; and
the communication module (101) sends test data corresponding to the battery parameter to the test terminal (801) through the wireless communication interface, so that the test terminal (801) generates a test result based on the test data,
wherein the communication module (101) is integrated into the battery under test (102).

2. The communication module (101) according to claim 1, wherein the communication module (101) comprises a signal conversion module (401) configured to convert a signal type of the instruction data into a signal type suitable for the battery under test (102), and send, to the battery under test (102), a test instruction obtained after the conversion.

3. The communication module (101) according to claim 2, wherein the communication module (101) further comprises a first controller (402), wherein
the first controller (402) is configured to receive a first channel switching instruction sent by the test terminal (801), and control, according to the first channel switching instruction, the signal conversion module (401) to perform channel switching; or the communication module (101) further comprises a second controller (501), wherein
the signal conversion module (401) is further configured to receive a second channel switching instruction sent by the test terminal (801), and send the second channel switching instruction to the second controller (501); and
the second controller (501) controls, according to the second channel switching instruction, the signal conversion module (401) to perform channel switching.

4. The communication module (101) according to claim 2 or claim 3, wherein the communication module (101) further comprises a power supply, wherein
the power supply is configured to power the battery under test (102).

5. The communication module (101) according to any one of claims 1 to 3, wherein the test instruction comprises at least one of a BMS master control test instruction, a BMS slave control test instruction, a minimum voltage test instruction, a maximum voltage test instruction, a minimum temperature test instruction, a maximum temperature test instruction, an SOC detection instruction, an interlock signal fault detection instruction, a slow charging function detection instruction, and a fast charging function detection instruction.

6. A wireless test system for a battery, comprising a test terminal (801) and a communication module (101) according to any one of claims 1 to 5, wherein test software for testing a battery under test (102) is stored in the test terminal (801); optionally there are a plurality of communication modules (101), and the test terminal (801) is configured to wirelessly test a plurality of batteries under test by using the plurality of communication modules (101).

7. A wireless test method for a battery, wherein a battery under test (102) is communicatively connected to a test terminal (801) through a communication module (101), and the method comprises:
receiving, by the communication module (101), instruction data sent by the test terminal (801), and sending a test instruction corresponding to the instruction data to the battery under test (102);
receiving, by the communication module (101), a battery parameter sent by the battery under test (102) according to the test instruction, and sending test data corresponding to the battery parameter to the test terminal (801); and
generating, by the test terminal (801), a test result based on the test data, wherein the communication module (101) is integrated into the battery under test (102).

8. The method according to claim 7, wherein the communication module (101) comprises a signal conversion module (401) and a first controller (402); both the signal conversion module (401) and the first controller (402) are communicatively connected to the test terminal (801); and before the receiving instruction data sent by the test terminal (801), the method further comprises:
receiving, by the first controller (402), a first channel switching instruction sent by the test terminal (801), and controlling, according to the first channel switching instruction, the signal conversion module (401) to perform CAN channel switching; or the communication module (101) comprises a signal conversion module (401) and a second controller (501); the signal conversion module (401) is communicatively connected to the test terminal (801); and before the receiving instruction data sent by the test terminal (801), the method further comprises:
receiving, by the signal conversion module (401), a second channel switching instruction sent by the test terminal (801), and forwarding the second channel switching instruction to the second controller (501), wherein the second controller (501) controls, according to the second channel switching instruction, the signal conversion module (401) to perform CAN channel switching.

9. The method according to claim 7, wherein before the battery under test (102) arrives at a test station, a test process corresponding to the method is completed; or after the battery under test (102) leaves a test station, a test process corresponding to the method starts to be executed.

10. The method according to claim 7, wherein the test terminal (801) sends the instruction data to the communication module (101) after it is detected that the battery under test (102) has reached a preset station.

11. The method according to claim 7, wherein there are a plurality of communication modules (101), and each of the communication modules (101) is connected to at least one battery under test (102).

12. The method according to any one of claims 7 to 11, wherein the test instruction comprises at least one of a battery management system BMS master control test instruction, a BMS slave control test instruction, a minimum voltage test instruction, a maximum voltage test instruction, a minimum temperature test instruction, a maximum temperature test instruction, an SOC detection instruction, an interlock signal fault detection instruction, a slow charging function detection instruction, and a fast charging function detection instruction.

## Patentansprüche

1. Kommunikationsmodul (101), umfassend eine Drahtlos-Kommunikationsschnittstelle und eine kabelgebundene Kommunikationsschnittstelle (1011), wobei
das Kommunikationsmodul (101) über die Drahtlos-Kommunikationsschnittstelle in Drahtlos-Kommunikationsverbindung mit einem Test-Endgerät (801) steht und dazu konfiguriert ist, von dem Test-Endgerät (801) gesendete Anweisungsdaten zu empfangen;
das Kommunikationsmodul (101) über die kabelgebundene Kommunikationsschnittstelle (1011) mit einer zu testenden Batterie (102) verbunden ist und dazu konfiguriert ist, eine den Anweisungsdaten entsprechende Testanweisung an die zu testende Batterie (102) zu senden und einen entsprechenden Batterieparameter zu empfangen, der von der zu testenden Batterie (102) gemäß der Testanweisung erzeugt wird; und
das Kommunikationsmodul (101) über die Drahtlos-Kommunikationsschnittstelle Testdaten, die dem Batterieparameter entsprechen, an das Test-Endgerät (801) sendet, sodass das Test-Endgerät (801) auf Grundlage der Testdaten ein Testergebnis erzeugt,
wobei das Kommunikationsmodul (101) in die zu testende Batterie (102) integriert ist.

2. Kommunikationsmodul (101) nach Anspruch 1, wobei das Kommunikationsmodul (101) ein Signalumwandlungsmodul (401) umfasst, das dazu konfiguriert ist, einen Signaltyp der Anweisungsdaten in einen für die zu testende Batterie (102) geeigneten Signaltyp umzuwandeln und eine nach der Umwandlung erhaltene Testanweisung an die zu testende Batterie (102) zu senden.

3. Kommunikationsmodul (101) nach Anspruch 2, wobei das Kommunikationsmodul (101) ferner eine erste Steuereinheit (402) umfasst, wobei
die erste Steuereinheit (402) dazu konfiguriert ist, eine von dem Test-Endgerät (801) gesendete erste Kanalumschaltungsanweisung zu empfangen und gemäß der ersten Kanalumschaltungsanweisung das Signalumwandlungsmodul (401) zu steuern, um eine Kanalumschaltung durchzuführen; oder wobei das Kommunikationsmodul (101) ferner eine zweite Steuereinheit (501) umfasst, wobei
das Signalumwandlungsmodul (401) ferner dazu konfiguriert ist, eine von dem Test-Endgerät (801) gesendete zweite Kanalumschaltungsanweisung zu empfangen und die zweite Kanalumschaltungsanweisung an die zweite Steuereinheit (501) zu senden; und
die zweite Steuereinheit (501) gemäß der zweiten Kanalumschaltungsanweisung das Signalumwandlungsmodul (401) steuert, um eine Kanalumschaltung durchzuführen.

4. Kommunikationsmodul (101) nach Anspruch 2 oder Anspruch 3, wobei das Kommunikationsmodul (101) ferner eine Stromversorgung umfasst, wobei
die Stromversorgung dazu konfiguriert ist, die zu testende Batterie (102) mit Strom zu versorgen.

5. Kommunikationsmodul (101) nach einem der Ansprüche 1 bis 3, wobei die Testanweisung zumindest eines umfasst von: einer BMS-Master-Steuerungs-Testanweisung, einer BMS-Slave-Steuerungs-Testanweisung, einer Mindestspannungs-Testanweisung, einer Höchstspannungs-Testanweisung, einer Mindesttemperatur-Testanweisung, einer Höchsttemperatur-Testanweisung, einer SOC-Erfassungsanweisung, einer Verriegelungssignal-Fehlererfassungsanweisung, einer Erfassungsanweisung für eine Langsam-Laden-Funktion und einer Erfassungsanweisung für eine Schnellladungsfunktion.

6. Drahtlos-Testsystem für eine Batterie, umfassend ein Test-Endgerät (801) und ein Kommunikationsmodul (101) nach einem der Ansprüche 1 bis 5, wobei in dem Test-Endgerät (801) Test-Software zum Testen einer zu testenden Batterie (102) gespeichert ist; wobei optional mehrere Kommunikationsmodule (101) vorhanden sind und das Test-Endgerät (801) dazu konfiguriert ist, unter Verwendung der mehreren Kommunikationsmodule (101) mehrere zu testende Batterien drahtlos zu testen.

7. Drahtlos-Testverfahren für eine Batterie, wobei eine zu testende Batterie (102) über ein Kommunikationsmodul (101) kommunikativ mit einem Test-Endgerät (801) verbunden ist und das Verfahren umfasst:
Empfangen, durch das Kommunikationsmodul (101), von dem Test-Endgerät (801) gesendete Anweisungsdaten und Senden einer den Anweisungsdaten entsprechenden Testanweisung an die zu testende Batterie (102);
Empfangen, durch das Kommunikationsmodul (101), eines von der zu testenden Batterie (102) gemäß der Testanweisung gesendeten Batterieparameters und Senden von Testdaten, die dem Batterieparameter entsprechen, an das Test-Endgerät (801); und
Erzeugen, durch das Test-Endgerät (801), eines Testergebnisses auf Grundlage der Testdaten, wobei das Kommunikationsmodul (101) in die zu testende Batterie (102) integriert ist.

8. Verfahren nach Anspruch 7, wobei das Kommunikationsmodul (101) ein Signalumwandlungsmodul (401) und eine erste Steuereinheit (402) umfasst; sowohl das Signalumwandlungsmodul (401) als auch die erste Steuereinheit (402) kommunikativ mit dem Test-Endgerät (801) verbunden sind; und das Verfahren vor dem Empfangen der von dem Test-Endgerät (801) gesendeten Anweisungsdaten ferner umfasst:
Empfangen, durch die erste Steuereinheit (402), einer von dem Test-Endgerät (801) gesendeten ersten Kanalumschaltungsanweisung und Steuern, gemäß der ersten Kanalumschaltungsanweisung, des Signalumwandlungsmoduls (401), um eine CAN-Kanalumschaltung durchzuführen; oder wobei das Kommunikationsmodul (101) ein Signalumwandlungsmodul (401) und eine zweite Steuereinheit (501) umfasst; das Signalumwandlungsmodul (401) kommunikativ mit dem Test-Endgerät (801) verbunden ist; und das Verfahren vor dem Empfangen der von dem Test-Endgerät (801) gesendeten Anweisungsdaten ferner umfasst:
Empfangen, durch das Signalumwandlungsmodul (401), einer von dem Test-Endgerät (801) gesendeten zweiten Kanalumschaltungsanweisung und Weiterleiten der zweiten Kanalumschaltungsanweisung an die zweite Steuereinheit (501), wobei die zweite Steuereinheit (501) gemäß der zweiten Kanalumschaltungsanweisung das Signalumwandlungsmodul (401) steuert, um eine CAN-Kanalumschaltung durchzuführen.

9. Verfahren nach Anspruch 7, wobei ein dem Verfahren entsprechender Testprozess abgeschlossen wird, bevor die zu testende Batterie (102) an einer Teststation ankommt; oder wobei ein dem Verfahren entsprechender Testprozess zu starten beginnt, nachdem die zu testende Batterie (102) eine Teststation verlässt.

10. Verfahren nach Anspruch 7, wobei das Test-Endgerät (801) die Anweisungsdaten an das Kommunikationsmodul (101) sendet, nachdem erfasst wurde, dass die zu testende Batterie (102) eine voreingestellte Station erreicht hat.

11. Verfahren nach Anspruch 7, wobei mehrere Kommunikationsmodule (101) vorhanden sind und jedes der Kommunikationsmodule (101) mit zumindest einer zu testenden Batterie (102) verbunden ist.

12. Verfahren nach einem der Ansprüche 7 bis 11, wobei die Testanweisung zumindest eines umfasst von: einer Master-Steuerungs-Testanweisung eines Batteriemanagementsystems BMS, einer BMS-Slave-Steuerungs-Testanweisung, einer Mindestspannungs-Testanweisung, einer Höchstspannungs-Testanweisung, einer Mindesttemperatur-Testanweisung, einer Höchsttemperatur-Testanweisung, einer SOC-Erfassungsanweisung, einer Verriegelungssignal-Fehlererfassungsanweisung, einer Erfassungsanweisung für eine Langsam-Laden-Funktion und einer Erfassungsanweisung für eine Schnellladungsfunktion.

## Revendications

1. Module de communication (101), comprenant une interface de communication sans fil et une interface de communication filaire (1011), dans lequel
le module de communication (101) est en liaison de communication sans fil avec un terminal de test (801) par l'intermédiaire de l'interface de communication sans fil, et est configuré pour recevoir des données d'instruction envoyées par le terminal de test (801) ;
le module de communication (101) est connecté à une batterie à tester (102) par l'intermédiaire de l'interface de communication filaire (1011), et est configuré pour envoyer à la batterie à tester (102) une instruction de test correspondant aux données d'instruction, et recevoir un paramètre de batterie correspondant généré par la batterie à tester (102) conformément à l'instruction de test ; et
le module de communication (101) envoie, par l'intermédiaire de l'interface de communication sans fil, des données de test correspondant au paramètre de batterie au terminal de test (801), de sorte que le terminal de test (801) génère un résultat de test sur la base des données de test,
dans lequel le module de communication (101) est intégré dans la batterie à tester (102).

2. Module de communication (101) selon la revendication 1, dans lequel le module de communication (101) comprend un module de conversion de signal (401) configuré pour convertir un type de signal des données d'instruction en un type de signal adapté à la batterie à tester (102), et envoyer à la batterie à tester (102) une instruction de test obtenue après la conversion.

3. Module de communication (101) selon la revendication 2, dans lequel le module de communication (101) comprend en outre un premier contrôleur (402), dans lequel
le premier contrôleur (402) est configuré pour recevoir une première instruction de commutation de canal envoyée par le terminal de test (801), et commander, conformément à la première instruction de commutation de canal, le module de conversion de signal (401) pour effectuer une commutation de canal ; ou le module de communication (101) comprend en outre un second contrôleur (501), dans lequel
le module de conversion de signal (401) est en outre configuré pour recevoir une seconde instruction de commutation de canal envoyée par le terminal de test (801), et envoyer la seconde instruction de commutation de canal au second contrôleur (501) ; et
le second contrôleur (501) commande, conformément à la seconde instruction de commutation de canal, le module de conversion de signal (401) pour effectuer une commutation de canal.

4. Module de communication (101) selon la revendication 2 ou la revendication 3, dans lequel le module de communication (101) comprend en outre une alimentation électrique, dans lequel
l'alimentation électrique est configurée pour alimenter la batterie à tester (102).

5. Module de communication (101) selon l'une quelconque des revendications 1 à 3, dans lequel l'instruction de test comprend au moins l'une parmi une instruction de test de commande maître du BMS, une instruction de test de commande esclave du BMS, une instruction de test de tension minimale, une instruction de test de tension maximale, une instruction de test de température minimale, une instruction de test de température maximale, une instruction de détection du SOC, une instruction de détection de défaut de signal d'interverrouillage, une instruction de détection de fonction de charge lente et une instruction de détection de fonction de charge rapide.

6. Système de test sans fil pour une batterie, comprenant un terminal de test (801) et un module de communication (101) selon l'une quelconque des revendications 1 à 5, dans lequel un logiciel de test pour tester une batterie à tester (102) est stocké dans le terminal de test (801) ; éventuellement, il existe une pluralité de modules de communication (101), et le terminal de test (801) est configuré pour tester sans fil une pluralité de batteries à tester en utilisant la pluralité de modules de communication (101).

7. Procédé de test sans fil pour une batterie, dans lequel une batterie à tester (102) est connectée en communication à un terminal de test (801) par l'intermédiaire d'un module de communication (101), et le procédé comprend :
la réception, par le module de communication (101), de données d'instruction envoyées par le terminal de test (801), et
l'envoi, à la batterie à tester (102), d'une instruction de test correspondant aux données d'instruction ;
la réception, par le module de communication (101), d'un paramètre de batterie envoyé par la batterie à tester (102) conformément à l'instruction de test, et l'envoi, au terminal de test (801), de données de test correspondant au paramètre de batterie ; et
la génération, par le terminal de test (801), d'un résultat de test sur la base des données de test, dans lequel le module de communication (101) est intégré dans la batterie à tester (102).

8. Procédé selon la revendication 7, dans lequel le module de communication (101) comprend un module de conversion de signal (401) et un premier contrôleur (402) ; le module de conversion de signal (401) et le premier contrôleur (402) sont tous deux connectés en communication au terminal de test (801) ; et, avant la réception des données d'instruction envoyées par le terminal de test (801), le procédé comprend en outre :
la réception, par le premier contrôleur (402), d'une première instruction de commutation de canal envoyée par le terminal de test (801), et la commande, conformément à la première instruction de commutation de canal, du module de conversion de signal (401) pour effectuer une commutation de canal CAN ; ou le module de communication (101) comprend un module de conversion de signal (401) et un second contrôleur (501) ; le module de conversion de signal (401) est connecté en communication au terminal de test (801) ; et, avant la réception des données d'instruction envoyées par le terminal de test (801), le procédé comprend en outre :
la réception, par le module de conversion de signal (401), d'une seconde instruction de commutation de canal envoyée par le terminal de test (801), et le transfert de la seconde instruction de commutation de canal au second contrôleur (501), dans lequel le second contrôleur (501) commande, conformément à la seconde instruction de commutation de canal, le module de conversion de signal (401) pour effectuer une commutation de canal CAN.

9. Procédé selon la revendication 7, dans lequel, avant que la batterie à tester (102) arrive à une station de test, un processus de test correspondant au procédé est achevé ; ou, après que la batterie à tester (102) quitte une station de test, un processus de test correspondant au procédé commence à être exécuté.

10. Procédé selon la revendication 7, dans lequel le terminal de test (801) envoie les données d'instruction au module de communication (101) après qu'il a été détecté que la batterie à tester (102) a atteint une station prédéfinie.

11. Procédé selon la revendication 7, dans lequel il existe une pluralité de modules de communication (101), et chacun des modules de communication (101) est connecté à au moins une batterie à tester (102).

12. Procédé selon l'une quelconque des revendications 7 à 11, dans lequel l'instruction de test comprend au moins l'une parmi une instruction de test de commande maître du système de gestion de batterie BMS, une instruction de test de commande esclave du BMS, une instruction de test de tension minimale, une instruction de test de tension maximale, une instruction de test de température minimale, une instruction de test de température maximale, une instruction de détection du SOC, une instruction de détection de défaut de signal d'interverrouillage, une instruction de détection de fonction de charge lente et une instruction de détection de fonction de charge rapide.
